# EUROPÄISCHE PATENTSCHRIFT

(11) **EP 3 233 345 B1**
(45) Veröffentlichungstag und Bekanntmachung des Hinweises auf die Patenterteilung: **02.11.2022**
(21) Anmeldenummer: 15808076.2
(22) Anmeldetag: 18.11.2015
(51) Int. Cl.: H05K 3/34, B23K 1/00, B23K 1/008, B23K 1/20, H05K 1/11, H05K 3/30, B23K 101/42

(54) **VERFAHREN ZUR VOIDREDUKTION IN LÖTSTELLEN**
METHOD FOR VOID REDUCTION IN SOLDER JOINTS
PROCÉDÉ DE RÉDUCTION DES VIDES DANS LES ZONES DE SOUDURE

(30) Priorität: 18.12.2014 AT 509242014
(43) Veröffentlichungstag der Anmeldung: 25.10.2017
(73) Patentinhaber: ZKW Group GmbH, 3250 Wieselburg (AT)
(72) Erfinder: EDLINGER, Erik, A-1090 Wien (AT)
(74) Vertreter: Patentanwaltskanzlei Matschnig & Forsthuber OG
(86) Internationale Anmeldenummer: PCT/AT2015/050295
(87) Internationale Veröffentlichungsnummer: WO 2016/094915

(56) Entgegenhaltungen:
- JP-A- S63 273 398
- JP-A- 2003 264 255
- US-A1- 2007 221 398
- US-A1- 2012 325 538

## Beschreibung

Die Erfindung betrifft ein Verfahren zum lötenden Verbinden zumindest eines elektronischen Bauteils mit einer Trägerplatte gemäß den Oberbegriffen der Ansprüche 1 und 4, wobei die Trägerplatte zumindest eine Trägerplattenkontaktfläche und das zumindest eine elektronische Bauteil zumindest eine dazu korrespondierende Bauteilkontaktfläche aufweist, wobei die zumindest eine Trägerplattenkontaktfläche von einer Lötstopplackschicht umgeben ist, die die zumindest eine Trägerplattenkontaktfläche begrenzt.

Das Anbringen von elektronischen Bauteilen an Trägerplatten, beispielsweise an Printplatten oder Leiterplatten, ist ein sehr häufig erforderlicher Vorgang bei der Herstellung von elektrischen Schaltkreisen. Printplatten weisen dabei im Allgemeinen Leiterbahnen auf, die einzelne oder mehrere Anschlusskontakte miteinander verbinden, wobei einzelne elektronische Bauteile mit den elektrischen Anschlusskontakten verbunden werden. Die Verbindung kann mehrere Aspekte wie beispielsweise eine elektrische, mechanische und/oder thermische Verbindung erfüllen.

Aus dem Stand der Technik sind unterschiedliche Methoden bekannt geworden, mit Hilfe derer eine Verbindung eines elektronischen Bauteils mit einer Trägerplatte realisiert werden kann. So können beispielsweise Kontaktflächen einzelner elektronischer Bauteile, folgend auch als Bauteilkontaktflächen bezeichnet, mit an den Trägerplatten angeordneten Kontaktflächen (folgend auch als Trägerplattenkontaktflächen bezeichnet) verlötet werden.

An dieser Stelle sei auf das SMT-Verfahren (Surface Mount Technology) verwiesen, bei welchem sich die elektrischen Anschlüsse bzw. Kontaktflächen des elektronischen Bauteils sowie die korrespondierenden Kontaktflächen der Trägerplatte jeweils an deren Oberfläche befinden und die elektronischen Bauteile lediglich an der Oberfläche der Trägerplatte befestigt werden müssen und auf das Vorsehen von Durchgangsbohrungen verzichtet werden kann. Die Kontaktflächen der Trägerplatte werden hierbei zuerst mit einem Lötmittel, zumeist einer Lotpaste, beschichtet. Im Anschluss erfolgt die Bestückung der Trägerplatte mit einzelnen elektronischen Bauteilen.

Zur Herstellung einer dauerhaften elektrischen und/oder thermischen und/oder mechanischen Verbindung der elektronischen Bauteile mit der Trägerplatte ist beispielsweise das Reflow-Lötverfahren bekannt geworden, bei welchem die Lotpaste und die Kontaktflächen nach der Bestückung mit den elektronischen Bauteilen dergestalt erhitzt werden, dass die Lotpaste schmilzt und sich mit den Kontaktflächen der Trägerplatte sowie des jeweiligen elektronischen Bauteils verbindet.

Im klassischen SMT- Prozess enthält eine Lotpaste sowohl ein Lötgut (welches die beteiligten Kontaktflächen dauerhaft verbindet) als auch Flussmittel, die die Lötbarkeit (insbesondere das Fluss- und Benetzungsverhalten) des Lötguts verbessern, indem sie Oxide auf den Oberflächen der Kontaktflächen entfernen. Überschüssiges, in der Lotpaste eingebettetes Flussmittel wird beim Erhitzen und Aufschmelzen der Lotpaste gasförmig und entweicht in Form von Bläschen. Die Lotpaste wird zumeist in einem Sieb- bzw. Masken-Druckprozess in Form von Lötdepots auf eine Trägerplatte aufgebracht, bevor elektronische Bauteile darauf platziert werden. Die Formen der Lotdepots folgen dabei im Allgemeinen der Form korrespondierender Trägerplattenkontaktflächen, sodass die Paste lediglich auf die Trägerplattenkontaktflächen aufgebracht wird.

Ein in der SMT-Technologie häufig auftretendes Problem ist die Bildung von als Lunker oder Voids bezeichneten Hohlräumen in den Lötstellen. Eine mögliche Ursache für die Entstehung von Voids liegt darin, dass das in der Lotpaste eingebettete Flussmittel beim Löten nicht vollständig aus dem Lot austreten kann und sich daher innerhalb der Lötstelle ansammelt. Diese Voids haben nicht nur einen negativen Einfluss auf die Lebensdauer und die thermische Leitfähigkeit der Lötstelle, sie können im schlimmsten Fall auch zum Totalausfall des elektronischen Bauteils führen und werden daher häufig als Ausschlusskriterium oder Qualitätsmerkmal herangezogen, das zu sehr hohen zusätzlichen Kosten bei der Produktion von Leiterplatten bzw. zu einem hohen Ausschuss an Leiterplatten führt. Hierbei ist die prozentuelle Fläche der Voids das Kriterium der Wahl für die Auswahl der Ausschuss-Teile. Bei besonders großen Bauteilen ist die Anzahl an Voids höher, da größere Bereiche der Oberfläche des gedruckten Lots vom Bauteil abgedeckt sind und das ausgasende Flussmittel daher einen längeren Weg zurücklegen muss, bis es über die freien Seitenflächen nach außen entweichen kann; folglich ist hier auch der Ausschuss um einiges höher. Wenn man die Ausbildung von Voids verhindern bzw. auf ein Minimum einschränken kann, könnte der Ausschuss daher deutlich reduziert werden.

Die US 8,678,271 B2 offenbart ein Verfahren zum Verhindern von Voidbildung, indem die Kontaktflächen mit einer vorgeformten Lotpastenschicht (unter Lot-Preform oder Solderpreform bekannt) bestückt werden. Die vorgeformte Lotpastenschicht wird vor dem Bestücken strukturiert, um Ausgaskanäle zum Ableiten von ausgasendem Flussmittel zu erzeugen.

Die US 2009/0242023 A1 offenbart ein Lötverfahren, bei welchem die Lotpaste in verschiedenen Strukturen gedruckt wird, um Ausgaskanäle zum Ableiten von ausgasendem Flussmittel zu erzeugen.

Die JPS63273398 A beschreibt ein Verfahren, bei welchem Lotpaste neben die Bereiche der Leiterplattenkontaktfläche gedruckt werden, wo die Bauteilkontaktflächen positioniert werden. Dazu ist die Leiterplattenkontaktfläche neben das Bauteil herausgezogen und die Lotpaste wird somit vor dem Löten neben dem bestückten Bauteil ausschließlich auf die Leiterplattenkontaktfläche aufgebracht. Beim Löten wird ein Anteil der geschmolzenen Lotpaste unter das Bauteil gezogen, wobei aber nicht zwingend eine Kapillarwirkung entsteht. Dieses Verfahren ist spezifisch für Bauteile, die über die Seitenflächen der Elektroden kontaktiert werden.

Die JP 2003 264255 A beschreibt ein Verfahren zum lötenden Verbinden eines Kontaktpins mit einer Trägerplatte.

Die US 2012/325538 A1 offenbart eine Leiterplattenanordnung, die mit elektronischen Komponenten, die mittels eines Lötverfahrens auf Kontaktflächen der Leiterplattenanordnung aufgebracht sind, bestückt ist.

US 2007/221398 A1 beschreibt ein Verfahren zum Herstellen einer Leiterplatte, wobei mit dem Verfahren eine reduzierte Voidbildung erhalten wird.

Es ist daher eine Aufgabe der Erfindung ein Lötverfahren bereitzustellen, mit welchem die Bildung von Voids in Lötstellen verhindert bzw. minimiert und auf diese Weise der Ausschuss an Leiterplatten reduziert sowie die Lebensdauer der gelöteten Bauteile erhöht werden kann.

Diese Aufgabe wird durch ein Verfahren zum lötenden Verbinden zumindest eines elektronischen Bauteils mit einer Trägerplatte gemäß den Merkmalen der unabhängigen Ansprüche 1 und 4 gelöst. Vorteilhafte Weiterbildungen sind in den abhängigen Ansprüchen beansprucht.

Dank der Erfindung, die eine gezielte atypische Verteilung der Lotpaste außerhalb der Pads auf der Lötstopplackschicht und mit lediglich minimaler Überlappung mit dem Pad vorsieht, können Voids in Lötstellen verhindert bzw. auf ein Minimum reduziert werden. Die Erfindung bedient sich der Fließeigenschaften der Lotpaste und nutzt zusätzlich den Kapillareffekt. Durch ein gezieltes Vermeiden von Lotpaste direkt unter dem Pad ist ein vorzeitiges Ausgasen überschüssigen Flussmittels möglich und somit eine Blasenbildung nahezu gänzlich vermeidbar. So konnte in Versuchen (siehe Beispiel 1 weiter unten) festgestellt werden, dass mit dem erfindungsgemäßen Lötverfahren die Ausbildung von Voids signifikant reduziert werden kann. Dadurch wird nicht nur der Ausschuss minimiert und die Lebensdauer der elektronischen Bauteile erhöht; auch die Menge der benötigten Lotpaste kann dank des erfindungsgemäßen Verfahrens um ca. 40% eingespart werden. Die Erfindung ist auf Lötstellen mit viereckiger, insbesondere rechteckiger, oder quadratischer Padform und auf jegliche Art von Bauteilen anwendbar.

Als für die Erfindung besonders geeignete Lotpasten sind SAC (SnAgCu) Lote z.B. SAC 305 (Bezugsquelle z.B.: Fa. Kester) und gängige flussmittelhältige rakelbare Lote zu nennen.

Für die Erfindung sind alle gängigen und einem Fachmann an sich bekannten Lötstopplacke, z.B. Epoxidharze, geeignet.

Die Kontaktflächen der Trägerplatte und der Bauteile sind mit Vorteil mit Zinn, Silber und/oder Gold beschichtet. Eine Zinn-, Silber- oder Goldschicht schützt die Kontaktflächen vor Korrosion und kann auf andere elektrisch leitende unterhalb der schützenden Schicht angeordnete Schichten (z.B. Kupfer) aufgetragen werden

In der Praxis sind die Trägerplattenkontaktflächen (trägerplattenseitigen Pads) bzw. die korrespondierenden Bauteilkontaktflächen (bauteilseitigen Pads) zumeist viereckig, insbesondere rechteckig mit jeweils zwei Längs- und Querseiten. Es sind jedoch auch Pads bekannt, die mehr als vier Seiten (Vielecke) aufweisen oder eine andere Form haben, wie z.B. eine kreisförmige oder ovale Form.

Der Begriff "in minimaler Überlappung mit der an die Lötstopplackschicht angrenzenden Trägerplattenkontaktfläche" wie hierin verwendet bedeutet, dass die Lotpaste nur soweit mit der Trägerplattenkontaktfläche und, nach dem Bestücken mit dem Bauteil, mit der Bauteilkontaktfläche überlappt, dass der Kapillareffekt, durch welchen das geschmolzene Lot in den Bereich zwischen Bauteilkontaktfläche und Trägerplattenkontaktfläche gezogen wird, zum Tragen kommt. Die Tiefe dieser Überlappung ist üblicherweise durch die Toleranzen des Aufdruckens der Lotpaste gegeben. Die Lotpaste wird zumeist nach an sich bekannter Art in einem Sieb- bzw. Masken-Druckprozess in Form von Lötdepots aufgebracht, bevor elektronische Bauteile darauf platziert werden. Erfindungsgemäß liegt die Tiefe der minimalen Überlappung der Lotpaste mit der Trägerplattenkontaktfläche in einem Bereich von 0,2 - 0,5 mm. Bevorzugt beträgt die Tiefe der minimalen Überlappung circa 0,3 mm; dies entspricht üblicherweise der zweifachen Toleranz des Druckvorgangs.

Die Trägerplattenkontaktfläche ist im Wesentlichen viereckig geformt und die Lotpaste wird in minimaler Überlappung mit der Trägerplattenkontaktfläche entlang einer Längsseite oder einer Querseite der Trägerplattenkontaktfläche auf die Lötstopplackschicht aufgebracht. Je nach dem verwendeten Design bzw. Layout der Trägerplattenkontaktflächen (Pads) wird die Lotpaste entlang einer Längsseite oder entlang einer Querseite (hierin auch als Schmalseite oder Breitseite bezeichnet) des Pads auf die angrenzende Lötstopplackschicht mit minimaler Überlappung mit dem Pad aufgebracht. Bei rechteckigen Trägerplattenkontaktflächen ist die Längsseite sinngemäß länger als die Querseite. Bei einer quadratischen Form der Trägerplattenkontaktfläche sind deren Längsseite und deren Querseite sinngemäß gleich lang.

Bei einer Untervariante wird die Lotpaste daher in minimaler Überlappung mit der Trägerplattenkontaktfläche entlang einer Längsseite der Trägerplattenkontaktfläche auf die Lötstopplackschicht aufgebracht.

Bei einer weiteren Untervariante wird die Lotpaste folglich in minimaler Überlappung mit der Trägerplattenkontaktfläche entlang einer Querseite der Trägerplattenkontaktfläche auf die Lötstopplackschicht aufgebracht.

Bietet man die Lotpaste neben nur einer Seitenkante der Kontaktfläche in minimaler Überlappung mit der Seitenkante an, dann breitet sich die Lötfront typischerweise parallel zu dieser Kante aus.

Erfindungsgemäß wird die Überlappung der Lotpaste mit der Kontaktfläche entlang einer Seitenkante (Längsseite oder Querseite) variiert, d.h. die Überlappung steigt dabei von einem Minimalwert wie unten definiert ("minimale Überlappung") bereichsweise entlang der Seitenkante an. Dementsprechend wird die Lotpaste entlang einer Längsseite oder einer Querseite der Trägerplattenkontaktfläche auf die Lötstopplackschicht aufgebracht, wobei die Tiefe der Überlappung der Lotpaste mit der Trägerplattenkontaktfläche ausgehend von einer minimalen Überlappung bereichsweise entlang der Längsseite bzw. der Querseite ansteigt. Erfindungsgemäß wird die größte Überlappung an einem Ende der Seitenkante erreicht. Die größte Überlappung kann sich bei besonderen Weiterbildungen bis zu der gegenüberliegenden Seitenkante des Trägerplattenpads erstrecken. Bereiche größerer Überlappung sind sinnvoller Weise so vorgesehen, dass sie ein Verdrängen von Atmosphäre und Nachfließen von Lot in Bereichen erleichtern, wo ein Verdrängen erschwert ist. Auch diese Ausführungsform hat sich daher als besonders vorteilhaft bei großen Pads, bei welchen die Luft effektiv unter dem Bauteil verdrängt werden muss, erwiesen, z.B. für Leuchtdioden (LED) mit großen Trägerplattenkontaktflächen, z.B. die OSLON Black Flat LED mit zwei emittierenden Flächen.

Erfindungsgemäß liegt die Tiefe der minimalen Überlappung der Lotpaste mit einer im Wesentlichen rechteckigen Trägerplattenkontaktfläche entlang einer Längsseite der Trägerplattenkontaktfläche in einem Bereich von 0,2 - 0,5 mm. Bevorzugt beträgt die Tiefe der minimalen Überlappung circa 0,3 mm; dies entspricht üblicherweise der zweifachen Toleranz des Druckvorgangs.

In Bezug auf das Aufbringen von Lotpaste entlang einer Querseite einer im Wesentlichen rechteckigen Trägerplattenkontaktfläche, ist es erfindungsgemäß vorgesehen, dass die Tiefe der minimalen Überlappung der Lotpaste mit der Trägerplattenkontaktfläche entlang einer Querseite der Trägerplattenkontaktfläche in einem Bereich von 0,3 - 0,7 mm liegt. Bevorzugt beträgt die Tiefe der minimalen Überlappung ca. 0,5 mm.

Ist die Trägerplattenkontaktfläche im Wesentlichen quadratisch, d.h. die Längsseite und die Querseite sind im Wesentlichen gleich lang, dann liegt die Tiefe der minimale Überlappung der Lotpaste entlang einer Seitenkante der quadratischen Trägerplattenkontaktfläche in einem Bereich von 0,2 - 0,5 mm, bevorzugt bei ca. 0,3 mm.

Nach dem fehlerfreien Bestücken der Trägerplatte mit dem Bauteil entspricht die Tiefe der Überlappung der Lotpaste mit der Bauteilkontaktfläche im Wesentlichen der oben genannten Tiefe der Überlappung der Lotpaste mit der Trägerplattenkontaktfläche. Auf diese Weise wird der Kapillareffekt optimal ausgenutzt.

Zusätzlich zum Einsetzen des Kapillareffekts sorgt die Anpassung der Überlappung für Haftung und Befestigung des Bauteils auf der Trägerplatte während des Transports auf der SMT-Fertigungslinie.

Vorzugweise überdeckt die zumindest eine Bauteilkontaktfläche die dazu korrespondierende zumindest eine Trägerplattenkontaktfläche vollständig. Auf diese Weise kann der Kapillareffekt besonders gut genutzt werden.

In besonderen Ausführungsformen kann es vorteilhaft sein, wenn in oder nach dem Schritt b) das zumindest eine elektronische Bauteil zusätzlich mittels Klebepunkten an der Trägerplatte fixiert wird. Dies erlaubt eine besonders positionsstabile Fixierung des elektronischen Bauteils.

Bei einer vorteilhaften Weiterbildung dieser Ausführungsformen bestehen die Klebepunkte aus einem wärmehärtenden Klebematerial, wobei die für die Wärmehärtung erforderliche Temperatur unterhalb der Schmelztemperatur der Lotpaste liegt. Dies gewährleistet die Herstellung einer positionsstabilen Verbindung des zumindest einen elektronischen Bauteils mit der Trägerplatte bereits vor dem Schmelzen der Lotpaste, wodurch einem Verschieben, Verdrehen bzw. Verschwimmen des Bauteils zuverlässig vorgebeugt werden kann.

Alternativ dazu können auch beliebig andere Klebeverfahren und Klebematerialien verwendet werden.

In besonderen Ausführungsformen weist das zumindest eine elektronische Bauteil zumindest zwei Bauteilkontaktflächen auf und die Trägerplatte weist zumindest zwei jeweils korrespondierende Trägerplattenkontaktflächen auf. Bei diesen Ausführungsformen wird zwischen den Pads eine Art Luftkanal (Ausgaskanal) gebildet, der als Ableitung für das ausgasende Flussmittel und die unter dem Bauteil verdrängte Atmosphäre dient. Diese Ausführungsformen sind besonders bei großen Bauteilen von Vorteil. Das Design bzw. Layout, die Dimension und die Anzahl der Pads und der zwischen den Pads liegenden Ausgaskanäle werden zweckmäßigerweise in Abhängigkeit der maximal gemessenen Voidgröße und in Abhängigkeit der aufzubringenden Lotpaste dimensioniert, wobei dies im Ermessen und Können eines Fachmanns liegt. Die Kombination des erfindungsgemäßen Verfahrens mit dem entsprechenden Layout der Pads und Luftkanäle führt zu reproduzierbaren und voidfreien Lötstellen. Das Layout, die Dimension und die Anzahl der Pads auf der Bauteilseite werden üblicherweise von den Bauteilherstellern vorgegeben.

Die Erfindung ist sehr gut zum lötenden Verbinden von SMD-Bauteilen (*surface-mounted device*) sowie optoelektronischen Bauteilen, insbesondere LED-Bauteilen (*light emitting diode*)*,* mit Trägerplatten wie Leiterplatten geeignet. Die Erfindung ist ferner auch zum lötenden Verbindung von anderen optoelektronischen Bauteilen, z.B. Laser, von Vorteil.

Die Erfindung samt weiteren Ausgestaltungen und Vorteilen ist im Folgenden an Hand von beispielhaften, nicht einschränkenden Ausführungsformen näher erläutert, die in den beiliegenden Zeichnungen veranschaulicht sind. Hierbei zeigt
Fig. 1 eine perspektivische Ansicht einer Trägerplatte nach dem Aufdrucken der Lotpaste kurz vor dem Bestücken mit einem elektronischen Bauteil,
Fig. 2 a-c die einzelnen Schritte des erfindungsgemäßen Verfahrens, d.h. Aufdrucken von Lotpaste, Bestücken des elektronischen Bauteils und das Erhitzen der Lotpaste anhand von Schnittdarstellungen durch die Ansicht aus Fig. 1,
Fig. 3a und 3b eine erstarrte Lötverbindung mit Klebepunkten, die das elektronische Bauteil fixieren in Aufsicht (Fig. 3a) und in Seitenansicht (Fig. 3b),
Fig. 4 eine Aufsicht auf ein beispielhaftes Layout (nicht Teil der Erfindung) von Kontaktflächen und aufgedruckten Lotflächen zum lötenden Verbinden einer Diode mit vier Emitterflächen auf einer Trägerplatte,
Fig. 5 eine Aufsicht auf ein erfindungsgemäßes Layout von Kontaktflächen und aufgedruckten Lotflächen zum lötenden Verbinden einer Diode mit zwei Emitterflächen auf einer Trägerplatte,
Fig. 6 eine Aufsicht auf ein weiteres beispielhaftes Layout (nicht Teil der Erfindung) von Kontaktflächen und aufgedruckten Lotflächen zum lötenden Verbinden einer Diode mit zwei Emitterflächen auf einer Trägerplatte, und
Fig. 7 eine Aufsicht auf ein weiteres beispielhaftes Layout (nicht Teil der Erfindung) von Kontaktflächen und aufgedruckten Lotflächen zum lötenden Verbinden einer Diode mit zwei Emitterflächen auf einer Trägerplatte.

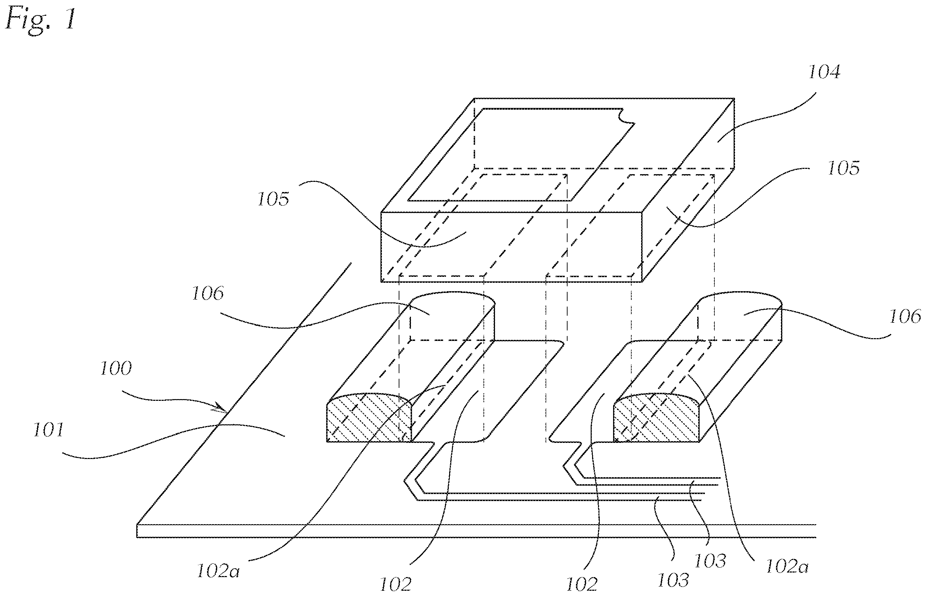

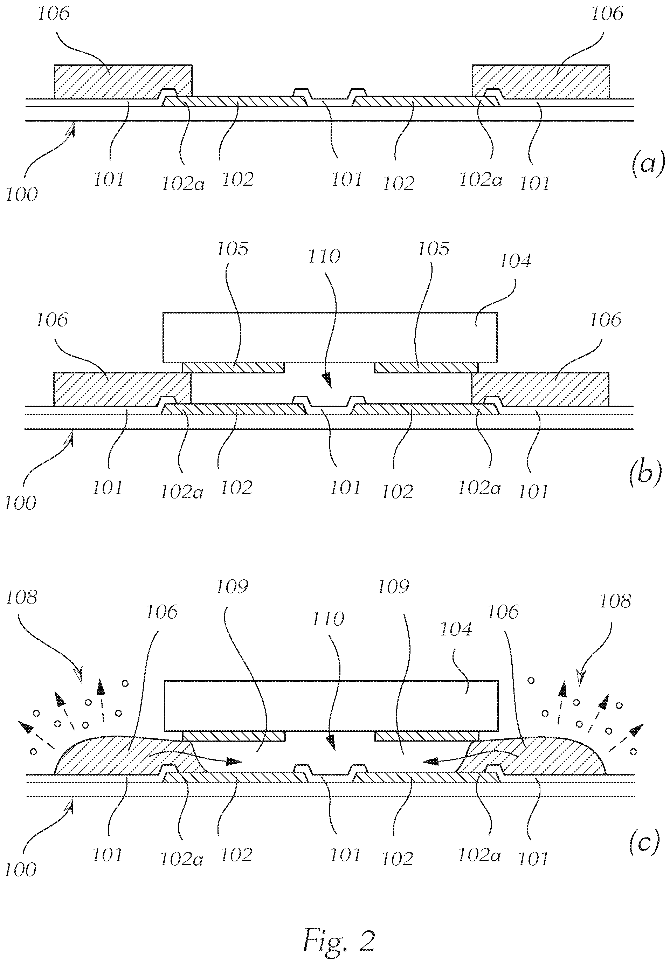

Fig. 1 zeigt eine perspektivische schematische Ansicht einer Trägerplatte 100 (Leiterplatte 100), die zwei Trägerplattenkontaktflächen 102 (Pads 2) und jeweils zwei zu den Trägerplattenkontaktflächen 102 führende Leitungen 103 aufweist. Die Trägerplattenkontaktflächen 102 sind jeweils als Teil einer Kupferfläche (siehe Fig. 2a-c), die vorzugsweise mit Silber, Zinn und/oder Gold beschichtet sein kann, ausgebildet, und sind nach an sich bekannter Art von einer Lötstopplackschicht 101 umgeben. Die Lötstopplackschicht 101 begrenzt die jeweiligen Trägerplattenkontaktflächen 102. Die Leitungen 103 können nach an sich bekannter Art auch unterhalb Lötstopplackschicht 101 verlaufen. Diese Trägerplatte 100 entspricht einer Trägerplatte, wie sie aus dem Stand der Technik bekannt ist. Entlang einer Längsseite 102a der jeweiligen Trägerkontaktflächen 102 ist Lotpaste 106 auf der Lötstopplackschicht 101aufgedruckt. Die Lotpaste 106 ist dabei so aufgedruckt, dass sie mit der Trägerkontaktfläche 102 entlang ihrer Längsseite 102a minimal überlappt. Die Tiefe dieser Überlappung ist üblicherweise durch die Toleranzen des Aufdruckens der Lotpaste 106 gegeben und beträgt im gezeigten Beispiel circa 0,3 mm; dies entspricht der üblichen zweifachen Toleranz des Druckvorgangs. Ein aus dem Stand der Technik bekanntes Verfahren zum Aufbringen von Lotpaste 106 ist das Stencil-Druckverfahren, welches das Aufbringen besonders genauer Formen von Lotpaste mit konstanter Höhe ermöglicht.

Fig. 1 zeigt ferner ein elektronisches Bauteil 104, hier eine LED, welches auf der Trägerplatte 100 über eine lötende Verbindung befestigt werden soll. Das Bauteil 104 weist zwei zu den Trägerplattenkontaktflächen 102 korrespondierende Bauteilkontaktflächen 105 auf. Die Bauteilkontaktflächen 105 sind durch strichlierte Linien angedeutet. Die Bauteilkontaktflächen 105 sind mit den Trägerkontaktflächen 102 im Wesentlichen deckungsgleich.

Fig. 2a-c zeigen die einzelnen Schritte des erfindungsgemäßen Verfahrens anhand von Schnittdarstellungen durch die Anordnung aus Fig. 1. Fig. 2a zeigt das Aufdrucken von Lotpaste 106 auf die Lötstopplackschicht 101 der Trägerplatte 100 entlang von jeweils einer Längsseite 102a der Trägerplattenkontaktflächen 102 und in minimaler Überlappung mit der Trägerplattenkontaktfläche 102. Fig. 2b zeigt das Bestücken der Trägerplatte 100 mit dem elektronischen Bauteil 104, wobei das Bauteil 104 so auf die Trägerplatte 100 positioniert wird, dass die jeweilige Bauteilkontaktfläche 105 die jeweils korrespondierende Trägerplattenkontaktfläche 102 überdeckt. Die Bauteilkontaktflächen 105 können nun mit der Lotpaste 106 bzw. dem darin enthaltenen Lot mit den Trägerplattenkontaktflächen 102 verbunden werden. Fig. 2c zeigt nun den Lötvorgang an sich, bei dem die Lotpaste 106 erhitzt wird und das in der Lotpaste 106 enthaltene Lot schmilzt und wird durch die Kapillarkräfte in den Lötstellenbereich 109 zwischen Trägerplattenkontaktfläche 102 und Bauteilkontaktfläche 105 gezogen. Das aus der Lotpaste 106 ausgasende Flussmittel entweicht nicht direkt im Lötstellenbereich 109, sondern bereits vorzeitig, wie durch das Bezugszeichen 108 angedeutet ist. Etwaige Bläschen, die sich doch nach innen in den Lötstellenbereich 109 bewegen, können über den Luftkanal 110, der zwischen den Trägerplattenkontaktflächen 102 gebildet wird, abgeleitet werden.

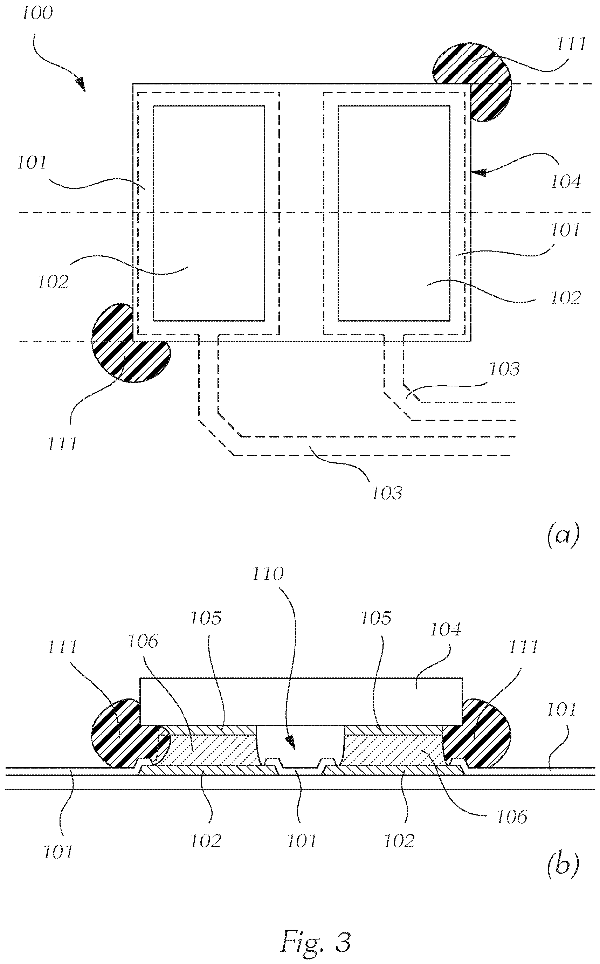

Fig. 3a-b zeigt eine Weiterbildung der in den Fig. 1 und 2a-c gezeigten erstarrten Lötverbindungsanordnung in Aufsicht (Fig. 3a) und in Seitenansicht (Fig. 3b). Bei der in den Fig. 3a und 3b gezeigten Lötverbindungsanordnung ist das elektronische Bauteil 104 zusätzlich mittels Klebepunkten 111 an der Trägerplatte 100 fixiert. Die Klebepunkte 111 sind an zwei gegenüberliegenden Ecken des im Wesentlichen rechteckigen Bauteils angeordnet, wobei jedoch auch andere Klebepunktanordnungen möglich sind. Das Vorsehen von Klebepunkten 111 erlaubt eine besonders positionstabile Fixierung des Bauteils 104. Die Klebepunkte 111 bestehen aus einem wärmehärtenden Klebematerial, wobei die für die Wärmehärtung der Klebepunkte erforderliche Temperatur unterhalb der Schmelztemperatur der Lotpaste 106 liegt. Beispielsweise können als wärmehärtendes Klebematerial Loctite 3621 (Bezugsquelle: Henkel) und als Lotpaste SAC305 (Bezugsquelle: Firma Kester) eingesetzt werden. Dies gewährleistet die Herstellung einer positionsstabilen Verbindung des Bauteils 104 mit der Trägerplatte 100 bereits vor dem Schmelzen der Lotpaste 106, wodurch einem Verschieben, Verdrehen bzw. Verschwimmen des Bauteils 104 zuverlässig vorgebeugt werden kann. Die strichliert eingezeichneten Flächen in Fig. 3a kennzeichnen jene Bereiche der Trägerplattenkontaktfläche 102 bzw. der Leitungen 103, die unter dem Lötstopplack 101 liegen. Aus Gründen der besseren Darstellbarkeit sind die Bereiche der rechteckigen Trägerplattenkontaktfläche 102, die nicht von Lötstopplack 101 bedeckt und für die Lötverbindung vorgesehen sind, als durchgezogene Linien gezeichnet; sie sind jedoch in der in Fig. 3a gezeigten Ansicht der Lötverbindungsanordnung durch das Bauteil 104 verdeckt und daher nicht sichtbar.

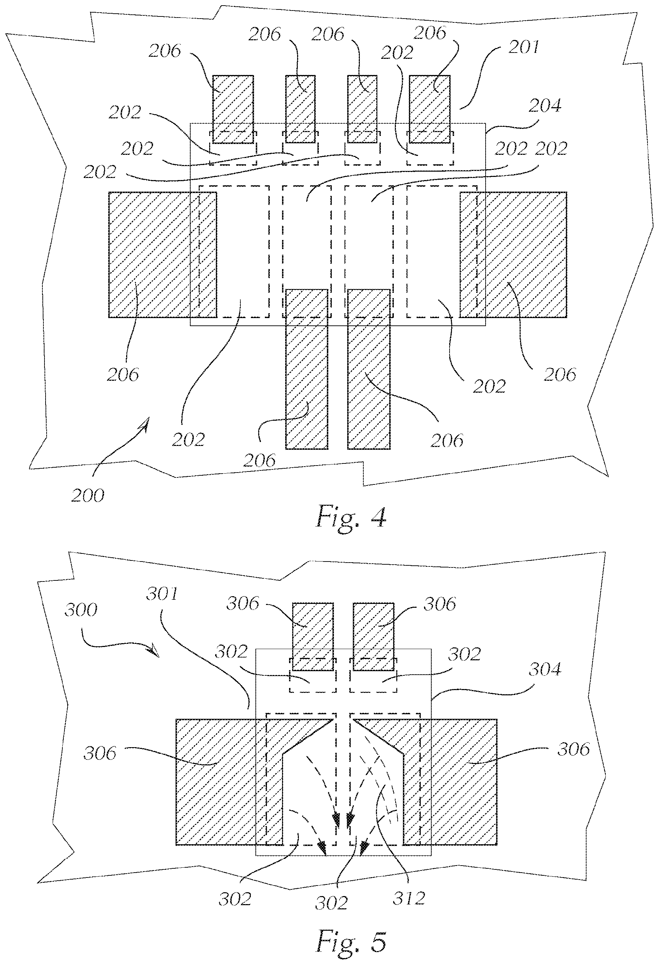

Fig. 4 zeigt eine Aufsicht auf ein beispielhaftes Layout (nicht Teil der Erfindung) von Trägerplattenkontaktflächen 202 (die Trägerplattenkontaktflächen 202 sind strichliert dargestellt, da sie in Aufsicht durch das aufgebrachte Bauteil 204 verdeckt sind) und darauf aufgedruckten Lotpastenflächen 206 zum lötenden Verbinden eines elektronischen Bauteils 204, hier eine Diode mit vier Emitterflächen, auf einer Trägerplatte 200. Die jeweils korrespondierenden Kontaktflächen der Trägerplatte 200 und des Bauteils 204 sind deckungsgleich. Die Überlappung der Druckbereiche der Lotpastenflächen 206 mit den Kontaktflächen 202 der Trägerplatte 200 bzw. mit den deckungsgleichen korrespondierenden Kontaktflächen des Bauteils 204 sind gut ersichtlich. Wie aus der Fig. 4 außerdem gut ersichtlich ist, wird die Lotpaste 206 entsprechend dem Layout entweder entlang einer Längsseite oder einer Querseite der jeweiligen Kontaktfläche auf die angrenzende Lötstopplackschicht 201 mit minimaler Überlappung mit der Kontaktfläche aufgetragen. Die Bereiche zwischen den einzelnen Kontaktflächen dienen während des Lötvorgangs als zusätzliche Ausgaskanäle für das entweichende Flussmittel wie oben zu Fig. 2a-c bereits im Detail beschrieben wurde.

Fig. 5 zeigt eine Aufsicht auf ein erfindungsgemäßes Layout von Trägerplattenkontaktflächen 302 (die Trägerplattenkontaktflächen 302 sind strichliert dargestellt, da sie in Aufsicht durch das aufgebrachte Bauteil 304 verdeckt sind) und darauf aufgedruckten Lotpastenflächen 306 zum lötenden Verbinden eines elektronischen Bauteils 304, hier eine Diode mit zwei Emitterflächen, auf einer Trägerplatte 300. Die jeweils korrespondierenden Kontaktflächen der Trägerplatte 300 und des Bauteils 304 sind deckungsgleich. Die beiden größeren Kontaktflächen 302 weisen eine große Padfläche und einen geringen Abstand zueinander auf. Wie aus der Fig. 5 klar ersichtlich ist, wird die Lotpaste 306 so auf die an die größeren Kontaktflächen 302 der Trägerplatte 300 angrenzende Lötstopplackschicht 301 aufgedruckt, dass die Überlappungsbereiche jeweils an einer Längsseite der Kontaktflächen 302 liegen, wobei die Tiefe der Überlappung ausgehend von einer minimalen Überlappung ansteigt. Die größte Überlappung wird an jeweils einem Ende der Längsseite erreicht, so dass beim Lötvorgang die Atmosphäre unter dem Bauteil in eine Richtung verdrängt werden kann. Dadurch kann die Ausbreitungsrichtung der Lötfront 312 beeinflusst werden und gibt - ohne an eine gewisse Theorie gebunden zu sein -für die zu entweichende Atmosphäre eine bestimmte Richtung vor. Die Variierung der Tiefe von Lotpastenüberlappungsbereichen an einer Seitenkante der Kontaktflächen, hier der Längsseite, ist besonders vorteilhaft bei großen Trägerplattenkontaktflächen und bei Kontaktflächen, die nur einen geringen Abstand zueinander aufweisen.

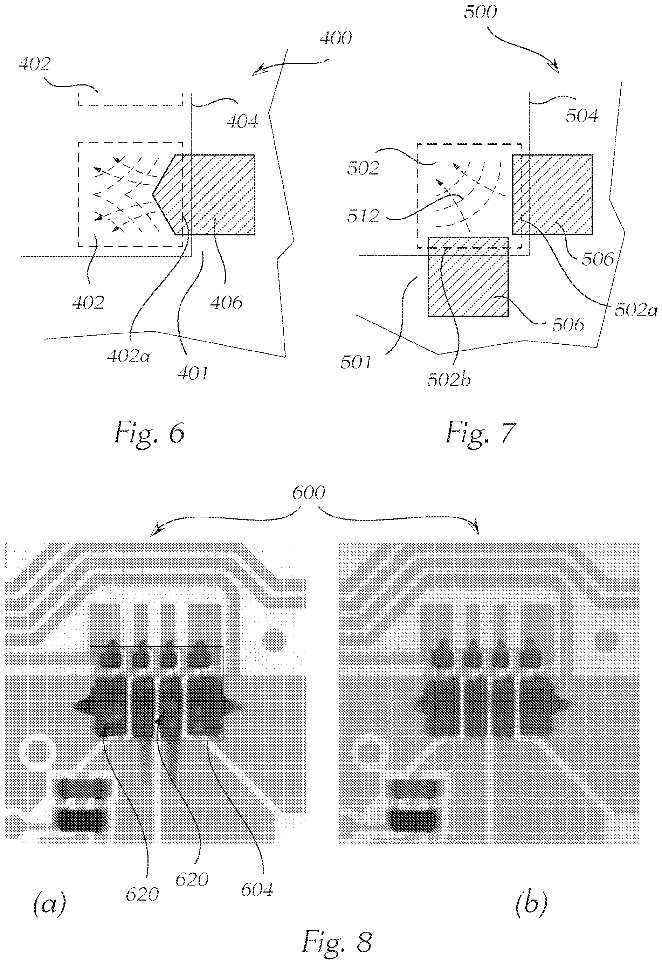

Fig. 6 zeigt eine Aufsicht auf ein weiteres beispielhaftes Layout (nicht Teil der Erfindung) von Trägerplattenkontaktflächen 402 (die Trägerplattenkontaktflächen 402 sind strichliert dargestellt, da sie in Aufsicht durch das aufgebrachte Bauteil 404 verdeckt sind) und darauf aufgedruckten Lotpastenflächen 406 zum lötenden Verbinden eines elektronischen Bauteils 404 (nur teilweise dargestellt), hier eine Diode mit zwei Emitterflächen, auf einer Trägerplatte 400. Die jeweiligen Kontaktflächen 402 der Trägerplatte 400 und die korrespondierenden Kontaktflächen des Bauteils 404 sind deckungsgleich. Die Kontaktfläche 402 ist im Wesentlichen quadratisch mit vier Seitenkanten und wird von einer Lötstopplackschicht 401 begrenzt. Wie aus der Fig. 6 klar ersichtlich ist, wird die Lotpaste 406 so auf die Lötstopplackschicht 401 aufgedruckt, dass die Tiefe der Überlappung mit einer Seitenkante 402a der Kontaktfläche 402 ausgehend von einer minimalen Überlappung, die ca. 0,3 mm beträgt, zur Mitte der Seitenkante 402a hin ansteigt. Auch diese Variante ermöglicht eine Beeinflussung der Ausbreitungsrichtung der Lötfront (durch Pfeile dargestellt) und gibt - ohne an eine gewisse Theorie gebunden zu sein - für die zu entweichende Atmosphäre eine bestimmte Richtung vor. Auch diese Variante ist besonders vorteilhaft bei großen Trägerplattenkontaktflächen und bei Kontaktflächen, die nur einen geringen Abstand zueinander aufweisen.

Fig. 7 zeigt eine Aufsicht auf ein weiteres beispielhaftes Layout (nicht Teil der Erfindung) einer Trägerplattenkontaktfläche 502 (die Trägerplattenkontaktfläche 502 ist strichliert dargestellt, da sie in Aufsicht durch das aufgebrachte Bauteil 504 verdeckt ist) und einer darauf aufgedruckten Lotpastenfläche 506 zum lötenden Verbinden eines elektronischen Bauteils 504, hier eine Diode mit zwei Emitterflächen, auf einer Trägerplatte 500. Die Kontaktflächee 502 der Trägerplatte 500 und die korrespondierende Kontaktfläche des Bauteils 504 sind deckungsgleich. Die Kontaktfläche 502 ist im Wesentlichen quadratisch mit vier Seitenkanten und wird von einer Lötstopplackschicht 401 begrenzt. Wie aus der Fig. 7 klar ersichtlich ist, wird die Lotpaste 506 so auf Lötstopplackschicht 501 aufgedruckt, dass die Überlappungsbereiche der Lotpaste 506 mit der Kontaktfläche 502 jeweils an einer ersten Seitenkante 502a und einer zweiten Seitenkante 502b, die an die erste Seitenkante 502a angrenzt, liegen, so dass die Atmosphäre unter dem Bauteil beim Lötvorgang in eine Richtung verdrängt werden kann. Bei rechteckigen Kontaktflächen wird die Lotpaste 506 zumindest bereichsweise entlang einer Längsseite und entlang einer Querseite (Breitseite, Schmalseite) der Kontaktfläche 502 aufgebracht. Auch diese Variante ermöglicht eine Beeinflussung der Ausbreitungsrichtung der Lötfront 512 (auch durch Linien und Pfeile dargestellt) und gibt - ohne an eine gewisse Theorie gebunden zu sein - für die zu entweichende Atmosphäre eine bestimmte Richtung vor. Auch diese Variante ist besonders vorteilhaft bei großen Trägerplattenkontaktflächen und bei Kontaktflächen, die nur einen geringen Abstand zueinander aufweisen.

### Beispiel 1: Vergleich der Ausbildung von Voids beim lötenden Verbinden von elektronischen Bauteilen auf Leiterplatten mit dem hierin beschriebenen Löterfahren und mit einem Standard-Lötverfahren.

In diesem Beispiel wurde die Ausbildung von Voids beim lötenden Verbinden von Bauteilen auf Leiterplatten mit dem hierin beschriebenen Lötverfahren und mit einem Standard-Lötverfahren verglichen.

Für die Vergleichsversuche wurden IMS Leiterplatten des Herstellers EUROSIR (Aluminium IMS mit 1,5mm Aluminium-Dicke, Insulated Metal Substrate) verwendet. Als Lotpaste wurde eine SAC305-Lotpaste (Hersteller/Bezugsquelle: Fa. Kester) und für den Reflow-Lötprozess wurde ein Lötofen der Firma Rehm verwendet.

Für die Versuche unter Einsatz des hierin beschriebenen Lötverfahrens und des Standardverfahrens wurden Leiterplatten mit einem LED-Bauteil des Typs Oslon Black Flat 1x4 (Hersteller: Osram) und sechs LED-Bauteilen des Typs Oslon Compact bestückt. Dabei bildeten 24 Leiterplatten einen Nutzen und werden gleichzeitig im Reflow Prozess verarbeitet. Die Temperaturrampen des Aufheiz- und Abkühlprozess, sowie die Haltezeiten folgen dem JEDEC- Standard. Die Gesamtdauer des Reflow-Prozesses betrug 300 sec, die Maximaltemperatur von 260°C wurde für 5 sec gehalten.

Anschließend an den jeweiligen Lötvorgang nach dem hierin beschriebenen Verfahren bzw. dem Standardverfahren wurden die Lötverbindungen in einem Röntgengerät von Matrix Technologies auf Voids analysiert. Bei einem Voidanteil über 30% der Kontaktfläche eines einzelnen Pads galt eine gelötete Leiterplatten/Bauteil-Anordnung als Ausfall.

### Standardgemäßes Lötverfahren:

Beim standardgemäßen Lötverfahren wurde die Lotpaste direkt und ausschließlich auf die Pads der Leiterplatte aufgedruckt. Somit befindet sich das gesamte angebotene Lot nach Bedrucken und Bestücken direkt unter den LED-Bauteilen. Im Anschluss an des Reflow-Löten wurde festgestellt, dass 20% der verarbeiteten Leiterplatten aufgrund von Void-Ausbildung nicht den oben genannten Kriterien entsprachen und daher als Ausschuss gewertet wurden. Fig. 8 (a) zeigt ein Röntgenbild einer Leiterplatte mit verlöteten LED-Bauteilen (mit dem Bezugszeichen 604 versehen). Metallflächen erscheinen in drei Graustufen abnehmender Helligkeit: Cu-Bahnen und Spreizflächen, Lot-bedeckte Kontaktflächen und darüber liegende Emitterflächen. Die gebildeten blasenförmigen Voids (größere Voids mit dem Bezugszeichen 620 angezeigt) erscheinen im Grauton der darunter liegenden Cu-Flächen. Bei Fig. 8 (a) ist der Voidanteil von 30% bei der dritten Kontaktfläche von links überschritten.

### Hierin beschriebenes Lötverfahren:

Beim hierin beschriebenen Lötverfahren wurde die Lotpaste (Lotpaste 206) gemäß dem in Fig. 4 dargestellten beispielhaften Layout (nicht Teil der Erfindung) auf die Lötstopplackschicht (Lötstopplackschicht 201) der Leiterplatte (Trägerplatte 200) in minimaler Überlappung mit den Längs- bzw. Querseiten der Pads/Kontaktflächen (Trägerplattenkontaktflächen 202) der Leiterplatte gedruckt. Bietet man das Lot gemäß dem erfindungsgenäßen Verfahren im Wesentlichen außerhalb der Kontaktflächen, d.h. nur in minimaler Überlappung mit den Kontaktflächen von Bauteil und Leiterplatte an, wurde an ca. 1500 untersuchten Leiterplatten nur ein einziger Ausfall festgestellt. Fig. 8 (b) zeigt dass die Lötstellen im Wesentlichen frei von Voids sind und dass nur minimale Voids in den Bereichen des Kontaktflächenrandes, über die das Lot unter das Bauteil gezogen wurde vorhanden sind.

Die Erfindung kann in beliebiger dem Fachmann bekannter Weise abgeändert werden und ist nicht auf die gezeigte Ausführungsform beschränkt, sondern nur durch die Ansprüche. Auch können einzelne Aspekte der Erfindung aufgegriffen und weitgehend miteinander kombiniert werden. Wesentlich sind die der Erfindung zugrunde liegenden Gedanken, welche in Anbetracht dieser Lehre durch einen Fachmann in mannigfaltiger Weise ausgeführt werden können und trotzdem als solche aufrechterhalten bleiben.

## Patentansprüche

1. Verfahren zum lötenden Verbinden zumindest eines elektronischen Bauteils (304) mit einer Trägerplatte (300), wobei die Trägerplatte zumindest eine Trägerplattenkontaktfläche (302) und das zumindest eine elektronische Bauteil zumindest eine dazu korrespondierende Bauteilkontaktfläche aufweist, wobei die zumindest eine Trägerplattenkontaktfläche von einer Lötstopplackschicht (301) umgeben ist, die die zumindest eine Trägerplattenkontaktfläche begrenzt, wobei das Verfahren die folgenden Schritte umfasst:
a) zumindest bereichsweises Aufbringen von Lotpaste (306) auf die Lötstopplackschicht (301) und in Überlappung mit der an die Lötstopplackschicht angrenzenden Trägerplattenkontaktfläche (302),
b) Bestücken der Trägerplatte mit dem zumindest einen elektronischen Bauteil (304) wobei die zumindest eine Bauteilkontaktfläche die dazu korrespondierende zumindest eine Trägerplattenkontaktfläche (302) zumindest teilweise überdeckt, und
c) Erhitzen der Lotpaste (306) zum Herstellen einer gelöteten Verbindung zwischen der Trägerplatte und dem zumindest einem Bauteil,
**dadurch gekennzeichnet, dass**
die Trägerplattenkontaktfläche (302) im Wesentlichen viereckig, insbesondere rechteckig, geformt ist und die Lotpaste (306) in minimaler Überlappung mit der Trägerplattenkontaktfläche entlang einer Längsseite oder einer Querseite der Trägerplattenkontaktfläche auf die Lötstopplackschicht (301) aufgebracht wird,
wobei die Tiefe der minimalen Überlappung der Lotpaste mit der Trägerplattenkontaktfläche, wenn die Lotpaste entlang der Längsseite der Trägerplattenkontaktfläche aufgebracht wird, entlang der Längsseite der Trägerplattenkontaktfläche in einem Bereich von 0, 2 - 0,5 mm liegt, und
wobei die Tiefe der minimalen Überlappung der Lotpaste mit der Trägerplattenkontaktfläche, wenn die Lotpaste entlang der Querseite der Trägerplattenkontaktfläche aufgebracht wird, entlang der Querseite der Trägerplattenkontaktfläche in einem Bereich von 0,3 - 0,7 mm liegt, und
wobei die Tiefe der Überlappung der Lotpaste mit der Trägerplattenkontaktfläche ausgehend von einer minimalen Überlappung bereichsweise entlang der Längsseite bzw. der Querseite ansteigt und die größte (maximale) Überlappung an einem Ende der Längsseite bzw. der Querseite erreicht wird.

2. Verfahren nach Anspruch 1, **dadurch gekennzeichnet, dass** die Tiefe der minimalen Überlappung der Lotpaste mit der Trägerplattenkontaktfläche entlang der Längsseite der Trägerplattenkontaktfläche bei circa 0,3 mm liegt.

3. Verfahren nach Anspruch 1, **dadurch gekennzeichnet, dass** die Tiefe der minimalen Überlappung der Lotpaste mit der Trägerplattenkontaktfläche entlang der Querseite der Trägerplattenkontaktfläche bei circa 0,5 mm liegt.

4. Verfahren zum lötenden Verbinden zumindest eines elektronischen Bauteils mit einer Trägerplatte, wobei die Trägerplatte zumindest eine Trägerplattenkontaktfläche und das zumindest eine elektronische Bauteil zumindest eine dazu korrespondierende Bauteilkontaktfläche aufweist, wobei die zumindest eine Trägerplattenkontaktfläche von einer Lötstopplackschicht umgeben ist, die die zumindest eine Trägerplattenkontaktfläche begrenzt, wobei das Verfahren die folgenden Schritte umfasst:
a) zumindest bereichsweises Aufbringen von Lotpaste auf die Lötstopplackschicht und in Überlappung mit der an die Lötstopplackschicht angrenzenden Trägerplattenkontaktfläche,
b) Bestücken der Trägerplatte mit dem zumindest einen elektronischen Bauteil wobei die zumindest eine Bauteilkontaktfläche die dazu korrespondierende zumindest eine Trägerplattenkontaktfläche zumindest teilweise überdeckt, und
c) Erhitzen der Lotpaste zum Herstellen einer gelöteten Verbindung zwischen der Trägerplatte und dem zumindest einem Bauteil,
**dadurch gekennzeichnet, dass**
die Trägerplattenkontaktfläche im Wesentlichen quadratisch geformt ist und die Lotpaste in minimaler Überlappung mit der Trägerplattenkontaktfläche entlang einer Längsseite oder einer Querseite der quadratischen Trägerplattenkontaktfläche, wobei die Längsseite und die Querseite im Wesentlichen gleich lang sind, auf die Lötstopplackschicht aufgebracht wird,
wobei die Tiefe der minimalen Überlappung der Lotpaste mit der Trägerplattenkontaktfläche entlang der Längsseite bzw. der Querseite der Trägerplattenkontaktfläche in einem Bereich von 0, 2 - 0,5 mm liegt, und
wobei die Tiefe der Überlappung der Lotpaste mit der Trägerplattenkontaktfläche ausgehend von einer minimalen Überlappung bereichsweise entlang der Längsseite bzw. der Querseite ansteigt und die größte (maximale) Überlappung an einem Ende der Längsseite bzw. der Querseite erreicht wird.

5. Verfahren nach Anspruch 4, **dadurch gekennzeichnet, dass** die Tiefe der minimalen Überlappung der Lotpaste mit der Trägerplattenkontaktfläche entlang der Längsseite bzw. Querseite der Trägerplattenkontaktfläche bei circa 0,3 mm liegt.

6. Verfahren nach einem der Ansprüche 1 bis 5, **dadurch gekennzeichnet, dass** sich die größte (maximale) Überlappung bis zu der gegenüberliegenden Seitenkante der Trägerplattenkontaktfläche (302) erstreckt.

7. Verfahren nach Anspruch 1 oder 2, **dadurch gekennzeichnet, dass** die Lotpaste (306) in minimaler Überlappung mit der Trägerplattenkontaktfläche (302) entlang einer Längsseite der Trägerplattenkontaktfläche auf die Lötstopplackschicht (301) aufgebracht wird und dass sich die größte (maximale) Überlappung bis zu der gegenüberliegenden Längsseite der Trägerplattenkontaktfläche (302) erstreckt.

8. Verfahren nach einem der Ansprüche 1 bis 7, **dadurch gekennzeichnet, dass** die zumindest eine Bauteilkontaktfläche die dazu korrespondierende zumindest eine Trägerplattenkontaktfläche (302) vollständig überdeckt.

9. Verfahren nach einem der Ansprüche 1 bis 8, **dadurch gekennzeichnet, dass** in oder nach dem Schritt b) das zumindest eine elektronische Bauteil zusätzlich mittels Klebepunkten an der Trägerplatte fixiert wird.

10. Verfahren nach Anspruch 9, **dadurch gekennzeichnet, dass** die Klebepunkte aus einem wärmehärtenden Klebematerial bestehen, wobei die für die Wärmehärtung erforderliche Temperatur unterhalb der Schmelztemperatur der Lotpaste liegt.

11. Verfahren nach einem der Ansprüche 1 bis 10, **dadurch gekennzeichnet, dass** das zumindest eine elektronische Bauteil (304) zumindest zwei Bauteilkontaktflächen aufweist und die Trägerplatte zumindest zwei jeweils korrespondierende Trägerplattenkontaktflächen (302) aufweist.

12. Verfahren nach einem der Ansprüche 1 bis 11, **dadurch gekennzeichnet, dass** das zumindest eine elektronische Bauteil ein optoelektronisches Bauteil ist.

13. Verfahren nach Anspruch 12, **dadurch gekennzeichnet, dass** das zumindest eine optoelektronische Bauteil eine LED ist.

14. Verfahren nach einem der Ansprüche 1 bis 11, **dadurch gekennzeichnet, dass** das zumindest eine elektronische Bauteil ein SMD-Bauteil ist.

## Claims

1. A process to connect, by soldering, at least one electronic component (304) with a mounting plate (300), the mounting plate having at least one mounting plate contact surface (302), and the at least one electronic component having at least one component contact surface corresponding to the at least one mounting plate contact surface, the at least one mounting plate contact surface being surrounded by a solder resist layer (301) that borders the at least one mounting plate contact surface, the process comprising:
a) applying solder paste (306) onto at least areas of the solder resist layer (301) overlapping with the mounting plate contact surface (302) adjacent to the solder resist layer,
b) equipping the mounting plate with the at least one electronic component (304), the at least one component contact surface at least partly covering the mounting plate contact surface (302) corresponding to the at least one component contact surface; and
c) heating the solder paste (306) to produce a soldered connection between the mounting plate and the at least one electronic component,
**characterized in that**
the mounting plate contact surface (302) is essentially quadrilateral, in particular rectangular, in shape and the solder paste (306) is applied to the solder resist layer (301) along a long side or a transverse side of the mounting plate contact surface and minimally overlaps with the mounting plate contact surface,
wherein the depth of the minimum overlap of the solder paste with the mounting plate contact surface along the long side of the mounting plate contact surface, when the solder paste is applied along the long side of the mounting plate contact surface, lies in a range of about 0.2-0.5 mm; and
wherein the depth of the minimum overlap of the solder paste with the mounting plate contact surface along the transverse side of the mounting plate contact surface, when the solder paste is applied along the transverse side of the mounting plate contact surface, lies in a range of about 0.3-0.7 mm;
wherein, starting from the minimum overlap, the depth of the overlap of the solder paste with the mounting plate contact surface increases in areas along the long side and the transverse side, respectively, and wherein the largest (maximum) overlap is reached at one end of the long side and the transverse side, respectively.

2. The process according to claim 1, **characterized in that** the depth of the minimum overlap of the solder paste with the mounting plate contact surface along the long side of the mounting plate contact surface is about 0.3 mm.

3. The process according to claim 1, **characterized in that** the depth of the minimum overlap of the solder paste with the mounting plate contact surface along the transverse side of the mounting plate contact surface is about 0.5 mm.

4. A process to connect, by soldering, at least one electronic component with a mounting plate, the mounting plate having at least one mounting plate contact surface, and the at least one electronic component having at least one component contact surface corresponding to the at least one mounting plate contact surface, the at least one mounting plate contact surface being surrounded by a solder resist layer that borders the at least one mounting plate contact surface, the process comprising:
a) applying solder paste onto at least areas of the solder resist layer overlapping with the mounting plate contact surface adjacent to the solder resist layer;
b) equipping the mounting plate with the at least one electronic component, the at least one component contact surface at least partly covering the at least one mounting plate contact surface corresponding to the at least one component contact surface; and
c) heating the solder paste to produce a soldered connection between the mounting plate and the at least one electronic component;
**characterized in that**
the mounting plate contact surface is essentially square and the solder paste is applied to the solder resist layer along a long side or a transverse side of the mounting plate contact surface, the long side and the transverse side being of essentially the same length and minimally overlapping with the mounting plate contact surface,
wherein the depth of the minimum overlap of the solder paste with the mounting plate contact surface along the long side or the transverse side of the mounting plate contact surface lies in a range of about 0.2-0.5 mm;
wherein, starting from the minimum overlap, the depth of the overlap of the solder paste with the mounting plate contact surface increases in areas along the long side and the transverse side, respectively, and wherein the largest (maximum) overlap is reached at one end of the long side and the transverse side, respectively.

5. The process according to claim 4, **characterized in that** the depth of the minimum overlap of the solder paste with the mounting plate contact surface along the long side or the transverse side of the mounting plate contact surface is about 0.3 mm.

6. The process according to any one of claims 1 to 5, **characterized in that** the largest (maximum) overlap extends all the way to the opposite side edge of the mounting plate contact surface (302).

7. The process according to claim 1 or 3, **characterized in that** the solder paste (306) is applied to the solder resist layer (301) along the long side of the mounting plate contact surface and minimally overlaps with the mounting plate contact surface (302); and **in that** the largest (maximal) overlap extends all the way to the opposite long side of mounting plate contact surface.

8. The process according to any one of claims 1 to 7, **characterized in that** the at least one component contact surface completely covers the at least one mounting plate contact surface (302) corresponding to the at least one component contact surface.

9. The process according to any one of claims 1 to 8, **characterized in that** during or after step b), the at least one electronic component is additionally fixed to the mounting plate by adhesive points.

10. The process according to claim 9, **characterized in that** the adhesive points consist of a thermosetting adhesive material, and wherein the temperature required for the thermosetting is less than the melting point of the solder paste.

11. The process according to any one of claims 1 to 10, **characterized in that** the at least one electronic component (304) comprises at least two component contact surfaces, and the mounting plate contact surface comprises at least two mounting plate contact surfaces (302) corresponding to the at least two component contact surfaces.

12. The process according to any one of claims 1 to 11, **characterized in that** the at least one electronic component is an optoelectronic component.

13. The process according to claim 12, **characterized in that** the at least one optoelectronic component is an LED.

14. The process according to any one of claims 1 to 11, **characterized in that** the at least one electronic component is an SMD component.

## Revendications

1. Procédé de liaison par soudage d'au moins un composant électronique (304) à une plaque de support (300), la plaque de support comportant au moins une surface de contact de plaque de support (302) et ledit au moins un composant électronique comportant au moins une surface de contact de composant correspondante à celui-ci, ladite au moins une surface de contact de plaque de support étant entourée d'une couche de vernis d'arrêt de soudage (301) qui délimite ladite au moins une surface de contact de plaque de support, le procédé comprenant les étapes suivantes :
a) appliquer de la pâte à souder (306) sur la couche de vernis d'arrêt de soudage (301) au moins par zones et en chevauchement avec la surface de contact de plaque de support (302) adjacente à la couche de vernis d'arrêt de soudage,
b) équiper la plaque de support avec ledit au moins un composant électronique (304), ladite au moins une surface de contact de composant recouvrant au moins partiellement ladite au moins une surface de contact de plaque de support (302) correspondante, et
c) chauffer la pâte à souder (306) pour réaliser une connexion de soudage entre la plaque de support et ledit au moins un composant,
**caractérisé en ce que**
la surface de contact de plaque de support (302) est de forme essentiellement quadrangulaire, en particulier rectangulaire, et la pâte à souder (306) est appliquée sur la couche de vernis d'arrêt de soudage (301) en chevauchement minimal avec la surface de contact de plaque de support le long d'un côté longitudinal ou d'un côté transversal de la surface de contact de plaque de support,
la profondeur du chevauchement minimal de la pâte à souder avec la surface de contact de plaque de support étant comprise dans une plage de 0,2 à 0,5 mm le long du côté longitudinal de la surface de contact de plaque de support, lorsque la pâte à souder est appliquée le long du côté longitudinal de la surface de contact de plaque de support, et
la profondeur du chevauchement minimal de la pâte à souder avec la surface de contact de plaque de support étant comprise dans une plage de 0,3 à 0,7 mm le long du côté transversal de la surface de contact de plaque de support, lorsque la pâte à souder est appliquée le long du côté transversal de la surface de contact de plaque de support, et
la profondeur du chevauchement de la pâte à souder avec la surface de contact de plaque de support augmentant par zones le long du côté longitudinal ou du côté transversal en partant d'un chevauchement minimal et le chevauchement le plus grand (maximal) étant atteint à une extrémité du côté longitudinal ou du côté transversal.

2. Procédé selon la revendication 1, **caractérisé en ce que** la profondeur du chevauchement minimal de la pâte à souder avec la surface de contact de plaque de support le long du côté longitudinal de la surface de contact de plaque de support est d'environ 0,3 mm.

3. Procédé selon la revendication 1, **caractérisé en ce que** la profondeur du chevauchement minimal de la pâte à souder avec la surface de contact de plaque de support le long du côté transversal de la surface de contact de plaque de support est d'environ 0,5 mm.

4. Procédé de liaison par soudage d'au moins un composant électronique à une plaque de support, la plaque de support comportant au moins une surface de contact de plaque de support et ledit au moins un composant électronique comportant au moins une surface de contact de composant correspondante à celle-ci, ladite au moins une surface de contact de plaque de support étant entourée d'une couche de vernis d'arrêt de soudage qui délimite ladite au moins une surface de contact de plaque de support, le procédé comprenant les étapes suivantes :
a) appliquer de la pâte à souder (306) sur la couche de vernis d'arrêt de soudage (301) au moins par zones et en chevauchement avec la surface de contact de plaque de support (302) adjacente à la couche de vernis d'arrêt de soudage,
b) équiper la plaque de support avec ledit au moins un composant électronique (304), ladite au moins une surface de contact de composant recouvrant au moins partiellement ladite au moins une surface de contact de plaque de support (302) correspondante, et
c) chauffer la pâte à souder (306) pour réaliser une connexion de soudage entre la plaque de support et ledit au moins un composant,
**caractérisé en ce que**
la surface de contact de plaque de support est de forme essentiellement carrée et la pâte à souder est appliquée sur la couche de vernis d'arrêt de soudage en chevauchement minimal avec la surface de contact de plaque de support le long d'un côté longitudinal ou d'un côté transversal de la surface de contact carrée de la plaque de support, le côté longitudinal et le côté transversal étant essentiellement de même longueur,
la profondeur du chevauchement minimal de la pâte à souder avec la surface de contact de plaque de support le long du côté longitudinal ou du côté transversal de la surface de contact de plaque de support étant comprise dans une plage de 0,2 à 0,5 mm, et
la profondeur du chevauchement de la pâte à souder avec la surface de contact de plaque de support augmentant par zones le long du côté longitudinal ou du côté transversal en partant d'un chevauchement minimal et le chevauchement le plus grand (maximal) étant atteint à une extrémité du côté longitudinal ou du côté transversal.

5. Procédé selon la revendication 4, **caractérisé en ce que** la profondeur du chevauchement minimal de la pâte à souder avec la surface de contact de plaque de support le long du côté longitudinal ou du côté transversal de la surface de contact de plaque de support est d'environ 0,3 mm.

6. Procédé selon l'une quelconque des revendications 1 à 5, **caractérisé en ce que** le chevauchement le plus grand (maximum) s'étend jusqu'au bord latéral opposé de la surface de contact de plaque de support (302).

7. Procédé selon la revendication 1 ou 2, **caractérisé en ce que** la pâte à souder (306) est appliquée sur la couche de vernis d'arrêt de soudage (301) en chevauchement minimal avec la surface de contact de plaque de support (302) le long d'un côté longitudinal de la surface de contact de plaque de support, et **en ce que** le chevauchement le plus grand (maximal) s'étend jusqu'au côté longitudinal opposé de la surface de contact de plaque de support (302).

8. Procédé selon l'une quelconque des revendications 1 à 7, **caractérisé en ce que** ladite au moins une surface de contact de composant recouvre complètement ladite au moins une surface de contact de plaque de support (302) correspondante.

9. Procédé selon l'une des revendications 1 à 8, **caractérisé en ce que**, pendant ou après l'étape b), ledit au moins un composant électronique est en outre fixé à la plaque de support au moyen de points de collage.

10. Procédé selon la revendication 9, **caractérisé en ce que** les points de collage sont constitués d'un matériau adhésif thermodurcissable, la température nécessaire pour thermodurcissement étant inférieure à la température de fusion de la pâte à souder.

11. Procédé selon l'une quelconque des revendications 1 à 10, **caractérisé en ce que** ledit au moins un composant électronique (304) présente au moins deux surfaces de contact de composant et la plaque de support présente au moins deux surfaces de contact de plaque de support (302) respectivement correspondantes à celles-ci.

12. Procédé selon l'une quelconque des revendications 1 à 11, **caractérisé en ce que** ledit au moins un composant électronique est un composant optoélectronique.

13. Procédé selon la revendication 12, **caractérisé en ce que** ledit au moins un composant optoélectronique est une DEL.

14. Procédé selon l'une quelconque des revendications 1 à 11, **caractérisé en ce que** ledit au moins un composant électronique est un composant de type CMS.
